(19) Europäisches Patentamt
European Patent Office
Office européen des brevets

(11) **EP 0 626 583 B1**

(12) **EUROPÄISCHE PATENTSCHRIFT**

(45) Veröffentlichungstag und Bekanntmachung des Hinweises auf die Patenterteilung:
**16.08.2001   Patentblatt 2001/33**

(51) Int Cl.$^7$: **G01R 23/16**, G01S 7/02, G01S 7/52, G01M 7/00

(21) Anmeldenummer: **94107571.5**

(22) Anmeldetag: **17.05.1994**

(54) **Verfahren zur Ermittlung einer periodischen Struktur in einem Linienspektrum und Verwendung eines solchen Verfahrens**

Method for determining a periodic structure in a line spectrum and use of said method

Procédé de détermination d'une structure périodique dans un spectre de raies et utilisation dudit procédé

(84) Benannte Vertragsstaaten:
**DE ES FR GB IT SE**

(30) Priorität: **26.05.1993  DE 4317424**

(43) Veröffentlichungstag der Anmeldung:
**30.11.1994   Patentblatt 1994/48**

(73) Patentinhaber: **EADS Deutschland GmbH
81663 München (DE)**

(72) Erfinder:
• **Schroer, Wolfgang, Dr. Prof.
D-89081 Ulm (DE)**
• **Bauer, Christoph
D-89160 Dornstadt (DE)**
• **Schmid, Johannes, Dr.
D-89075 Ulm (DE)**

(74) Vertreter: **Meel, Thomas
Dornier GmbH
L H G
88039 Friedrichshafen (DE)**

(56) Entgegenhaltungen:
WO-A-93/03530          DE-A- 3 414 929
DE-A- 4 220 429        GB-A- 2 054 310
US-A- 4 241 350        US-A- 4 389 647

EP 0 626 583 B1

**Beschreibung**

Die Erfindung betrifft ein Verfahren zur Ermittlung einer periodischen Struktur in einem Linienspektrum nach dem Oberbegriff des Patentanspruchs 1 und eine Verwendung eines solchen Verfahrens nach dem Oberbegriff des Patentanspruchs 9.

In vielen technischen Bereichen ist erforderlich, aus einem Amplitudenspektrum (Betragsspektrum) eine periodische Struktur zu ermitteln. Aus dieser kann dann z.B. auf die zugrundeliegende Modulationsfrequenz geschlossen werden. Beispielsweise können in kohärenten Radar-Doppler-Spektren periodische Strukturen entstehen, die auf periodisch bewegte (rotierende) Teile, z.B. Hubschrauber-Rotorblätter und/oder die Drehbewegung einer Turbine eines Flugzeuges, zurückführbar sind. Solche Zusatzinformationen sind z.B. zur Zielklassifikation von Radarechos erforderlich, z.B. bei einer Radar-Bodenstation eines Flughafens.

Solche periodischen Strukturen treten aber z.B. auch in der Mechanik bei einer sogenannten Geräuschanalyse auf. Hier kann z.B. aus dem Geräusch (Luftschall und/oder Körperschall) einer spanenden Maschine, z.B. Dreh- oder Fräsmaschine, durch eine Spektralanalyse auf den Verschleißzustand eines Schneidwerkzeuges geschlossen werden. Dabei entsteht in dem Amplitudenspektrum eine periodische Struktur, die von der Drehbewegung der Dreh- oder Fräsmaschine herrührt.

Eine Ermittlung von periodischen Strukturen ist aber auch in vielen Gebieten der Elektrotechnik erforderlich, z.B. bei der Überwachung und/oder Identifizierung eines Rundfunksenders.

Bei solchen Anwendungsfällen kann z.B. mit einem analog arbeitenden Spektralanalysator ein Amplitudenspektrum (Betragsspektrum) ermittelt werden. Dieses enthält im allgemeinen eine Bezugslinie, die im folgenden auch Nullinie genannt wird, an die sich ein- oder beidseitig eine Vielzahl von Spektrallinien anschließt. Bei einem solchen Linienspektrum kann eine periodische Struktur, die z.B. von einer periodischen Amplitudenmodulation herrührt, dadurch bestimmt werden, daß zu jeder Spektrallinie, welche der Nullinie benachbart ist, die sogenannten Harmonischen, die im folgenden auch-Fortsetzungslinien genannt werden, ermittelt werden.

Eine solche Auswertung kann sehr schwierig oder nahezu unmöglich werden, wenn die zu ermittelnde periodische Struktur durch eine Vielzahl störender Spektrallinien, die z.B. von Rauschen und/oder nichtperiodischen deterministischen spektralen Anteilen herrühren, überdeckt und/oder maskiert ist.

Aus der Schrift GB 2054310 ist eine Vorrichtung und ein Verfahren bekannt, bei welchem die spektralen Komponenten eines Signalechos eines Doppler-Radars bezüglich der Frequenzabstände der Seitenbänder des Echosignals analysiert werden. Das System basiert auf der Annahme, daß sich bestimmte Radarziele auf Grund von eigentümlichen, spezifischen Reflexionszentren im Doppler-Spektrum ihres Reflexionsechos unterscheiden.

Der Erfindung liegt daher die Aufgabe zugrunde, ein gattungsgemäßes Verfahren anzugeben, mit welchem in zuverlässiger Weise eine Ermittlung von periodischen Strukturen in Amplitudenspektren ermöglicht wird. Der Erfindung liegt außerdem die Aufgabe zugrunde, Verwendungen eines solchen Verfahrens anzugeben.

Diese Aufgabe wird gelöst durch die in den kennzeichnenden Teilen der Patentansprüche 1 und 9 angegebenen Merkmale. Vorteilhafte Ausgestaltungen und/oder Weiterbildungen sind den Unteransprüchen entnehmbar.

Die Erfindung beruht auf der Verwendung der bekannten "Fuzzy Set Theory", die z.B. in der Veröffentlichung H. Maier, T. Bessner, Formalisiertes Ingenieurgefühl, Elektronik Journal 4/93, S. 14-23, beschrieben wird. Eine Verarbeitung elektrischer Signale mit Hilfe der Fuzzy Set Theory ist möglich durch entsprechend gestaltete elektronische Schaltkreise und/oder durch eine Datenverarbeitungsanlage.

Die Erfindung wird im folgenden anhand eines Ausführungsbeispiels unter Bezugnahme auf schematisch dargestellte Diagramme näher erläutert. Es zeigen:

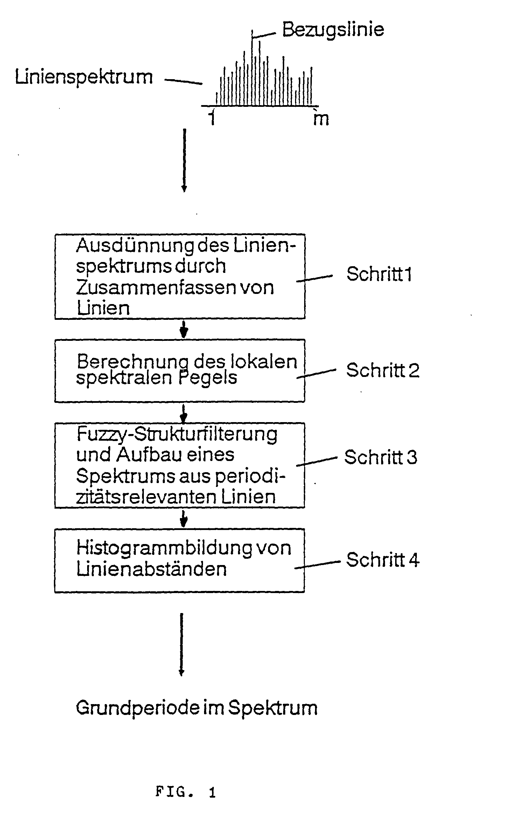

FIG. 1 bis FIG. 5        schematisch dargestellte Blockdiagramme zur Erläuterung des Verfahrens.

FIG. 1 zeigt ein Blockdiagramm zur Erläuterung des in vier Verfahrensschritte, Schritt 1 bis Schritt 4 unterteilten Verfahrens. Dieses geht aus von einem in digitaler Form vorliegendem Originalspektrum, das als Amplitudenspektrum (Betragsspektrum) ausgebildet ist und ein Linienspektrum mit m Spektrallinien darstellt. Ein solches Linienspektrum ist z.B. aus einem digitalisierten elektrischen Signal durch DFT (Diskrete Fourier Transformation) herstellbar. In einem solchen Spektrum haben die Spektrallinien einen minimalen Frequenzabstand dF, der durch die bei der DFT verwendete Abtastrate bestimmt wird. Das Spektrum besitzt eine Bezugslinie (Nullinie), die z.B. in einem kohärenten Radar-Doppler-Spektrum der Radialgeschwindigkeit eines Zieles, z.B. eines Hubschraubers, entspricht. Beiderseits der Bezugslinie sind Spektrallinien vorhanden, die unter anderem auf periodisch bewegte Teile, z.B. des Hauptrotors des beispielhaft erwähnten Hubschraubers, rückführbar sind. Ein sich drehender Hauptrotor erzeugt in dem Linienspektrum eine periodische (Linien-)Struktur, die bestimmt werden soll. Es ist vorteilhaft, den Frequenzabstand dF wesentlich kleiner zu wählen als die gesuchte Periode P, z.B. $dF \leq 0,1\ P$. Eine periodische Struktur zeigt sich in dem Spektrum durch eine im (Frequenz-)Abstand $i \cdot a \cdot dF$ (i = 1, 2, 3...; a = ganze Zahl) von der Bezugslinie wiederkehrende Vergrößerung der Spektrallinien gegenüber ihrer Umgebung. Dabei ist $P = a \cdot dF$ die gesuchte Periode P in dem Original-Amplitudenspektrum. In vielen Anwendungsfällen besitzt jedoch das Original-Amplitudenspektrum eine wesentlich höhere spektrale Auflösung, z.B. dF = 0,01 P, als diejenige, die zur Bestimmung der Periode P erforderlich ist. In einem solchen Fall wird zunächst eine Ausdünnung des Spektrums (Verringerung der Anzahl der Spektrallinien) auf eine definierte vorgebbare Anzahl von Spektrallinien vorgenommen (Schritt 1 in FIG. 1).

Die weitere Ermittlung (Schritte 2 bis 4) der gesuchten Grundperiode P stützt sich auf eine durch die erwähnte Fuzzy Set Theory vorgegebene regelbasierte Auswertung der Spektrallinien. Hierdurch werden zunächst im allgemeinen mehrere sogenannte relevante Spektrallinien ausgewählt und damit ein sogenanntes Rest-Spektrum gebildet. Jede relevante Spektrallinie kann der gesuchten Grundperiode P entsprechen, das heißt, die Grundperiode P wird zunächst nicht eindeutig bestimmt. Aus dem auf diese periodizitätsrelevanten Linien verringerten Rest-Spektrum wird die gesuchte Grundperiode P durch Histogrammierung von Linienabständen des Original-Amplitudenspektrums ermittelt.

Dieses aus einzelnen Vefahrensschritten zusammengesetzte Verfahren wird nachfolgend noch näher erläutert. Dabei bedeuten

Schritt 1:  die bereits erwähnte Ausdünnung des Original-Linienspektrums auf eine bestimmbare vorgebbare Linienzahl;

Schritt 2:  die Ermittlung eines lokalen spektralen Pegels und eine zugehörige Schwellen-Filterung der Amplituden der Spektrallinien des ausgedünnten Spektrums;

Schritt 3:  Fuzzy Strukturfilterung zur Ermittlung der perioditätsrelevanten Linien und ein sich daraus ergebender Aufbau des Rest-Spektrums;

Schritt 4:  Ermittlung der Grundperiode P durch Histogrammierung.

Diese Verfahrensschritte werden im folgenden im einzelnen näher erläutert:

Schritt 1: Ausdünnung des Original-Linienspektrums:

Bei diesem vorstehend erwähnten möglichen Verfahrensschritt kann durch die Verringerung der Anzahl der Spektrallinien (Verringerung der spektralen Auflösung) ein Informationsverlust auftreten, der jedoch vernachlässigbar ist. Durch die Verringerung der Anzahl der Spektrallinien auf eine bestimmte vorherbestimmte Anzahl wird jedoch der Bearbeitungsaufwand in vorteilhafter Weise erheblich verringert, so daß eine schnelle und kostengünstige Durchführung des Verfahrens ermöglicht wird, insbesondere mit Hilfe einer Datenverarbeitungsanlage.

Im ausgedünnten Spektrum stellt die Bezugslinie den Nullpunkt dar. Oberhalb bzw. unterhalb der Bezugslinie werden jeweils n aufeinanderfolgende Linien des Originalspektrums zu einer Linie im ausgedünnten Spektrum zusammengefaßt und dadurch der Linienabstand auf n·dF vergrößert. Als Ergebnis erhält man ko Linien oberhalb und ku Linien unterhalb der Bezugslinie (Nullpunkt), die als Amplitude das Maximum aus den jeweils n Linien des ursprünglichen Spektrums besitzen. Die Amplituden werden linear, d.h. nicht in logarithmischem Maßstab angegeben. n wird so gewählt, daß im ausgedünnten Spektrum eine Liniendichte erreicht wird, die etwa 10 mal größer ist als die zu suchende Periode P.

Die Amplitude der Bezugslinie ist für das Verfahren ohne Bedeutung. Die spektrale Lage der Bezugslinie definiert für das folgende Verfahren den Bezugs-(Null-)Punkt.

Ein Beispiel mit symmetrischer Bezugslinie (ku=ko): Aus 8192 spektralen Abtastpunkten mit Linie 4096 als Bezugslinie ergibt sich mit n=16 folgendes verdichtete Spektrum:

Maximum aus Linie 4097-4112 wird Linie +1
Maximum aus Linie 4095-4080 wird Linie -1
Maximum aus Linie 4113-4128 wird Linie +2
Maximum aus Linie 4079-4064 wird Linie -2
....
Maximum aus Linie 8188-8192 wird Linie 256*)
Maximum aus Linie 16- 1 wird Linie -256

*) Hier liegt eine Unregelmäßigkeit der Verdichtung vor, da eine Linie im Originalspektrum (wegen der Bezugslinie) "fehlt".

Schritt 2: Ermittlung des lokalen spektralen Pegels und Schwellen-Filterung:

Für das verdichtete (ausgedünnte) Spektrum wird ein lokaler spektraler Pegel bestimmt. Hierzu wird das Spektrum in Intervalle aus je u benachbarten Linien (z.B. u = 8) unterteilt, und für jedes Intervall der Mittelwert der Amplituden berechnet. In den folgenden Verfahrensschritten zur Ermittlung der periodizitätsrelevanten Linien werden nur noch Linien berücksichtigt, deren Amplituden den jeweiligen lokalen spektralen Pegel um einen bestimmten Faktor (typischer Wert 1) überschreiten. Jede Linie wird im folgenden durch ihre auf den zugeordneten lokalen spektralen Pegel normierte Amplitude (im folgenden als $A_n$ bezeichnet) repräsentiert.

Schritt 3: Fuzzy-Strukturfilterung zur Ermittlung periodizitätsrelevanter Linien und Aufbau eines Rest-Spektrums auf diesen periodizitätsrelevanten Linien:

In diesem Verfahrensschritt werden Linien selektiert, die eine periodische Fortsetzung im Spektrum beziehungsweise eine zum Nullpunkt symmetrische Ergänzung besitzen. Aus diesen relevanten Linien wird im Schritt 4 die Periode P ermittelt.

Die Selektion periodischer Linien erfolgt mit Fuzzy-Algorithmen. Zur Unterdrückung von Rauschen ermittelt der Fuzzy-Algorithmus einen Relevanzwert für alle periodisch wiederkehrenden Linien. Durch einen Schwellenvergleich werden wenig relevante Linien unterdrückt.

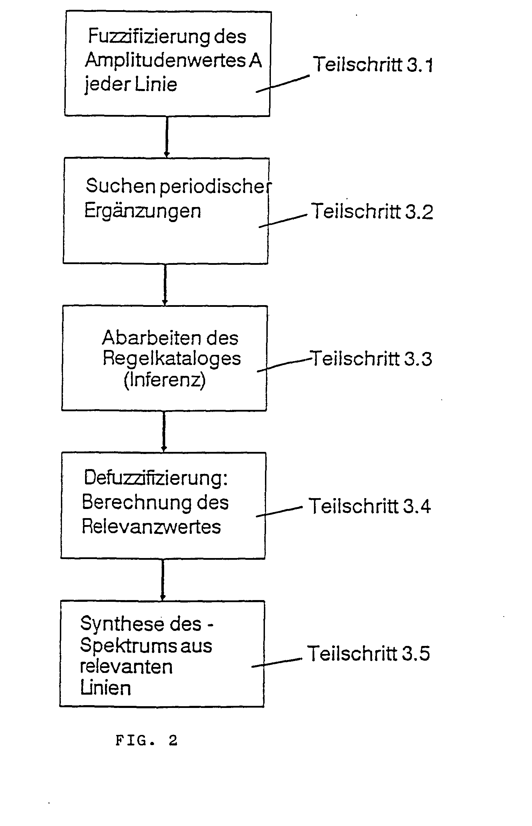

FIG. 2 zeigt in einem Blockdiagramm zu diesem Verfahrensschritt die einzelnen Teilschritte, die in folgenden erläutert werden.

Teilschritt 3.1:

Der Fuzzy-Algorithmus bewertet für jede Spektrallinie des ausgedünnten Spektrums den Amplitudenwert $A_n$, welcher dem linearen Signalabstand S/N entspricht, relativ zu dem zugehörigem lokalen spektralen Pegel (Schwellwert). Dieser lineare Signalabstand S/N (Amplitudenwert $A_n$) wird fuzzifiziert, das heißt unscharfen Klassen zugeordnet gemäß folgender Zuordnungsvorschrift:

| Klasse | $A_n$-Bereich |
|---|---|
| IG (kleiner als Schwelle) | $0 < A_n < 1$ |
| GG (gleich groß) | $0 < A_n < 2$ |
| G (größer als Schwelle) | $1 < A_n < 3$ |
| SG (sehr viel größer als Schwelle) | $2 < A_n < 4$ |
| UG (erheblich größer als Schwelle) | $3 < A_n < \infty$ |

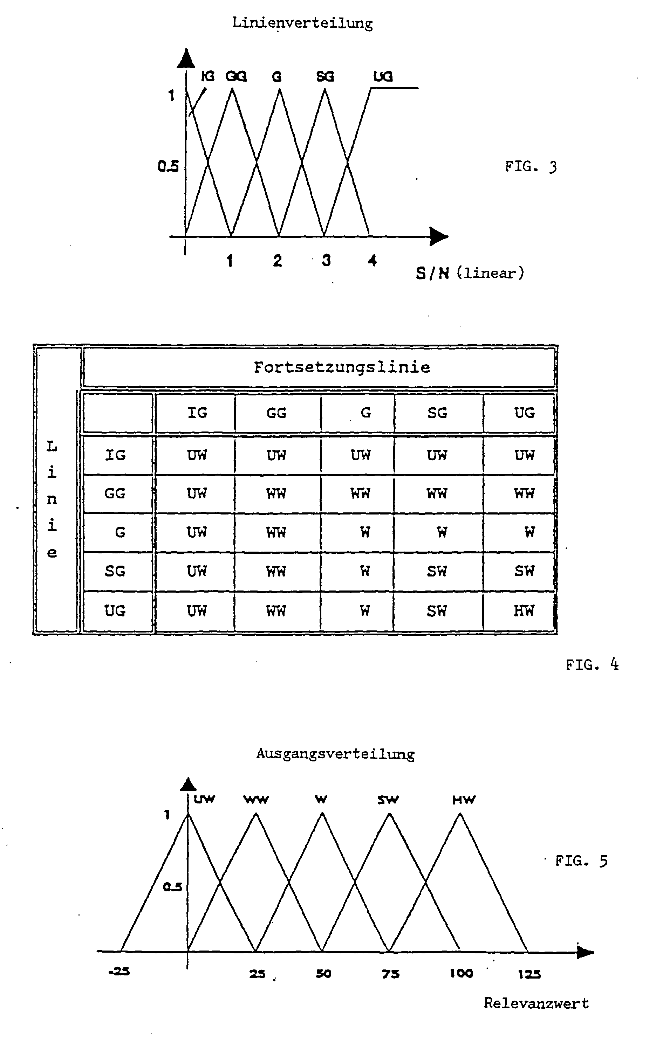

Dieses ist in FIG. 3 dargestellt. Dabei ist auf der Abszisse der lineare Störabstand S/N und auf der Ordinate der Zugehörigkeitsgrad (zwischen den Werten 0 und 1) aufgetragen. Die zu den Klassen gehörenden S/N-Wertebereiche sowie die Art der Überlappung (hier beispielsweise linear) müssen in Abhängigkeit von dem Anwendungsfall gewählt werden. Dieses ist einem Fachmann geläufig.

Teilschritt 3.2:

In diesem Teilschritt wird zu jeder Spektrallinie eine periodische Ergänzung gesucht.

Periodische Ergänzungen sind:

- Linien im doppelten Abstand zur Bezugslinie
- Linien mit zum Nullpunkt spiegelsymmetrischer Lage
- Linien mit doppelten Abstand auf der anderen Seite des Nullpunktes
- optional auch Linien im dreifachen Abstand auf beiden Seiten des Nullpunktes.

Zur Suche nach einer periodischen Ergänzung wird eine Fensterfunktion von +/-1 Linienabstand im ausgedünnten Spektrum angewendet, um Unregelmäßigkeiten auszugleichen, die durch das Zusammenfassen von Linien im Verfahrensschritt 1 bzw. durch sogenannte leakage-Effekte bei der Ermittlung des Spektrums verursacht werden.

Als periodische Ergänzung wird die größte im Fenster vorgefundene Linie, die auch Fortsetzungslinie genannt wird, ermittelt.

Teilschritt 3.3:

Jede im Teilschritt 3.2 ermittelte Linienpaarung wird nach einem Regelkatalog bewertet. FIG. 4 zeigt den Regelkatalog, der jeder möglichen Kombination der Amplitudenwerte der Linienpaarung eine der Relevanzklassen

HW    "hoch wahrscheinlich"
SW    "sehr wahrscheinlich"
W       "wahrscheinlich"
WW   "wenig wahrscheinlich"
UW    "unwahrscheinlich"

zuordnet. Den Relevanzklassen entsprechen Zahlenwerte von -25 bis 125, die auch Relevanzwerte genannt werden. In FIG. 5 ist für diese Relevanzklassen die Zugehörigkeit (Ordinate) in Abhängigkeit von den Relevanzwerten (Abszisse) dargestellt. Die hier dargestellte lineare Überlappung zwischen den Relevanzklassen ist in Abhängigkeit von dem Anwendungsfall zu wählen.

Die Zuordnung einer Linienpaarung (Spektrallinie und Fortsetzungslinie) in eine Relevanzklasse erfolgt aufgrund von in der Fuzzy-Set-Theory üblichen Verknüpfungsoperatoren, mit denen die gemäß Teilschritt 3.1 klassifizierten Linien verknüpft werden. Für den vorliegenden Anwendungsfall wird lediglich der "und"-Operator verwendet. Damit ergibt sich beispielsweise die folgende Verknüpfung.

Wenn   die Linie sehr groß (SG) ist
und      die Gegenlinie (Fortsetzungslinie) sehr groß (SG) ist
dann    ist die Kombination sehr wahrscheinlich (SW) ein relevantes Linienpaar.

Mit derartigen Verknüpfungen ist der Regelkatalog gemäß FIG. 4 herstellbar.

Teilschritt 3.4:

Da wegen der sich überlappenden Zugehörigkeitsfunktion (FIG. 3) der Amplitudenwerte $A_n$ (Eingangsgrößen) eine Zuordnung des Linienpaares, aufgrund der in Teilschritt 3.3 erwähnten Verknüpfungen, in mehrere Relevanzklassen möglich ist, muß der Relevanzwert der Paarung durch Defuzzifizierung ermittelt werden. Als Defuzzifizierungsmethode wird die sogenannte COA (center of average)-Methode angewandt. Es wird als Ergebnis ein Relevanzwert im Wertebereich

$$0 < = Relevanzwert < = 100$$

ermittelt.

Teilschritt 3.5:

Da im allgemeinen zu jeder Linie im ausgedünnten Spektrum mehrere periodische Ergänzungen vorhanden sind, wird jeder Linie der maximale für alle mit dieser Linie untersuchten Paarungen ermittelte Relevanzwert zugeordnet.
Durch Schwellenwertfilterung werden wenig relevante Linien ausgesondert. Als Schwelle wird z.B. ein Relevanzwert von 50 gewählt:.

Schritt 4: Periodenberechnung durch Histogrammierung

In den Schritten 1 bis 3 wurde ein sogenanntes Restspektrum erzeugt, das nur aus (Rest-)Linien besteht, bei denen ein vorgebbarer minimaler Relevanzwert überschritten wird. In diesem Verfahrensschritt wird nun damit die gesuchte Grundperiode P durch Histogrammierung ermittelt. Dazu werden zunächst im Restspektrum die (Frequenz-) Abstände der Restlinien zu der Bezugslinie ermittelt. Diese Abstände werden dann aufgrund der eingangs erwähnten Formeln auf zugehörige Abstände in dem Original-Amplitudenspektrum übertragen. In diesem werden dann zu jeder Restlinie die einfachen Abstände zur Bezugslinie (Nullpunkt) histogrammiert sowie einfache Bruchteile, das heißt 1/2, 1/3, 1/4, dieser Abstände. In dem Histogramm werden nun die mit Gewichtsfaktoren multiplizierten $A_n$-Werte der Restlinien und deren Harmonischen akkumuliert (zusammengezählt).

Für die Gewichtsfaktoren werden beispielsweise folgende Werte gewählt:

für einfache Abstände zum Nullpunkt Gewicht 1.0
für halbe, Drittel- und Viertelabstände Gewicht 0.9.

Als Grundperiode P wird nun derjenige Frequenzabstand gewählt, der in dem Histogramm den Maximalwert der akkumlierten Linien besitzt.

Das beschriebene Verfahren ist vorteilhafterweise sehr vielseitig anwendbar. Beispielsweise bei der erwähnten Auswertung von Radarechos eines Zieles. Es ist z.B. eine Unterscheidung (Klassifizierung) von Hubschraubern, Propeller- oder Düsenflugzeugen möglich. Weiterhin kann z.B. bei einem Sender dessen Modulationsart ermittelt werden. Damit ist eine technische Überwachung des Senders möglich.

## Patentansprüche

**1.** Verfahren zur Ermittlung einer periodischen Struktur in einem Linienspektrum, in dem eine spektrale Bezugslinie sowie mehrere an diese angrenzende Spektrallinien, die durch einen periodischen Modulationsvorgang entstanden sind, vorhanden sind, wobei

- zunächst eine Spektrallinie ausgewählt wird,

- zu dieser gehörende, im Linienspektrum periodisch angeordnete weitere Spektrallinien ermittelt werden und

- aus der derart ermittelten periodischen Struktur des Linienspektrums die zu dem Modulationsvorgang gehörenden Modulations-Parameter ermittelt werden, <u>dadurch gekennzeichnet,</u>

- daß aus einem in analoger Form vorliegenden Eingangssignal durch einen digitalen Abtastvorgang sowie eine Fouriertransformation zunächst ein in digitaler Form vorliegendes Amplitudenspektrum gebildet wird,

- daß in dem Amplitudenspektrum jeweils eine vorgebbare Anzahl benachbarter Spektrallinien zu einem Intervall zusammengefaßt werden,

- daß in jedem Intervall der Mittelwert der Amplituden der in diesem Intervall vorhandenen Spektrallinien ermittelt wird,

- daß in jedem Intervall jede dort vorhandene Spektrallinie bezüglich ihrer Amplitude und bezüglich des zu dem Intervall gehörenden Mittelwertes der Amplituden normiert wird

- daß die normierten Amplituden ($A_n$) in mehrere sich überlappende Amplitudenklassen (IG, GG, G, SG, UG) unterteilt werden,

- daß zumindest in der Umgebung der Bezugslinie zu jeder dort vorhandenen Spektrallinie eine periodische Ergänzung gesucht wird, so daß ein aus der Spektrallinie und einer Fortsetzungslinie bestehendes Linienpaar entsteht,

- daß jedes Linienpaar in Abhängigkeit von einer vorgebbaren Kombination seiner normierten Amplitudenklassen in eine Relevanzklasse eingeordnet wird,

- daß jeder Relevanzklasse ein vorgebbarer Relevanz-Wertebereich zugeordnet wird,

- daß zu jedem Linienpaar ein Relevanzwert ermittelt wird,

- daß von allen zu einer Spektrallinie gehörenden Linienpaaren der maximale Relevanzwert ermittelt und der Spektrallinie zugeordnet wird,

- daß aus Spektrallinien, deren Relevanzwert größer als ein vorgebbarer Schwellwert ist, ein Restspektrum

EP 0 626 583 B1

gebildet wird,

- daß zu jeder Spektrallinie des Restspektrums in dem digitalisierten Originalspektrum durch Histogrammierung die Anzahl der zugehörigen Fortsetzungslinien ermittelt wird,

- daß aus dem Histogramm die Spektrallinie mit der maximalen Anzahl von Fortsetzungslinien ermittelt wird und

- daß aus dem Frequenzabstand dieser Spektrallinie zu der Bezugslinie die Modulationsfrequenz bestimmt wird.

2. Verfahren nach Anspruch 1, dadurch gekennzeichnet, daß in dem in digitaler Form vorliegenden Amplitudenspektrum zunächst jeweils eine vorgebbare Anzahl (n) von Spektrallinien zu einer einzigen Spektrallinie zusammengefaßt werden und daß der einzigen Spektrallinie als Amplitudenwert der Maximalwert der Amplituden der zusammgefaßten Spektrallinien zugeordnet wird.

3. Verfahren nach Anspruch 1 oder Anspruch 2, dadurch gekennzeichnet, daß das in digitaler Form vorliegende Amplitudenspektrum eine Frequenzauflösung besitzt, die wesentlich kleiner ist als die penade des zu ermitteinden, Modulationsfrequenz und daß das Amplitudenspektrum in einem linearen Maßstab angegeben wird.

4. Verfahren nach einem der vorhergehenden Ansprüche, dadurch gekennzeichnet, daß die zu dem linearen Amplitudenspektrum gehörenden Amplitudenklassen und/oder die Relevanzklassen eine Zugehörigkeitsfunktion besitzen, die im Übergangsbereich einen linearen Verlauf besitzt.

5. Verfahren nach einem der vorhergehenden Ansprüche, dadurch gekennzeichnet, daß die zu einem Linienpaar gehörenden zwei Amplitudenklassen mit Hilfe eines UND-Operators kombiniert werden und das Ergebnis der Kombination einer vorgebbaren Relevanzklasse zugeordnet wird.

6. Verfahren nach einem der vorhergehenden Ansprüche, dadurch gekennzeichnet, daß die periodische Struktur mit Hilfe einer mit Methoden der Fuzzy-Set-Theory arbeitenden Datenverarbeitungsanlage ermittelt wird.

7. Verfahren nach einem der vorhergehenden Ansprüche, dadurch gekennzeichnet, daß in dem digitalisierten Originalspektrum bei den zu histogrammierenden Spektrallinien eine Gewichtung der Amplitudenwerte durchgeführt wird.

8. Verfahren nach einem der vorhergehenden Ansprüche, dadurch gekennzeichnet, daß zu einer aus dem Rest-Spektrum ermittelten Spektrallinie in dem digitalisierten Originalspektrum lediglich Spektrallinien mit einfachen Abständen und/oder einfachen Bruchteilen dieser Abstände histogrammiert werden.

9. Verwendung des Verfahrens zur Ermittlung einer periodischen Struktur nach einem der vorhergehenden Ansprüche zur Klassifizierung eines Luftfahrzeuges, das periodisch sich bewegende Bauelemente besitzt, die ein Radarsignal modulieren.

10. Verwendung des Verfahrens nach Anspruch 9 zur Erkennung und/oder Klassifizierung eines Hubschraubers.

**Claims**

1. Method for determining a cyclic structure in a line spectrum, in which a spectral reference line and a number of spectral lines which are adjacent to it and are produced by a cyclic modulation process are present, with

- first of all, one spectral line being selected,
- further spectral lines which are associated with this spectral line and are arranged cyclically in the line spectrum being determined, and
- the modulation parameters associated with the modulation process being determined from the cyclic structure of the line spectrum determined in such a manner,

characterized

- in that an amplitude spectrum, which is in digital form, is first of all formed by means of a digital sampling

7

process and a Fourier transformation from an input signal which is in analogue form,

- in that a predetermined number of adjacent spectral lines in the amplitude spectrum are in each case combined to form an interval,
- in that, in each interval, the mean value of the amplitudes of the spectral lines which are present in this interval is determined,
- in that, in each interval, each spectral line which is present there is normalized in terms of its amplitude and in terms of the mean value of the amplitudes associated with that interval,
- in that the normalized amplitudes ($A_n$) are subdivided into a number of overlapping amplitude classes (IG, GG, G, SG, UG),
- in that a cyclic supplement is looked for at least in the vicinity of the reference line relating to each spectral line which is present there, so that a pair of lines is produced which comprise the spectral line and a continuation line,
- in that each pair of lines is allocated to a relevance class as a function of a combination, which can be predetermined, of its normalized amplitude classes,
- in that each relevance class is allocated a relevance value range which can be predetermined,
- in that a relevance value is determined for each pair of lines,
- in that the maximum relevance value of all the pairs of lines associated with one spectral line is determined and is allocated to that spectral line,
- in that a residual spectrum is formed from spectral lines whose relevance value is greater than a threshold value which can be predetermined,
- in that the number of associated continuation lines is determined for each spectral line of the residual spectrum in the digitized original spectrum by histogram formation,
- in that the spectral line having the maximum number of continuation lines is determined from the histogram, and
- in that the modulation frequency is established from the frequency separation between this spectral line and the reference line.

2. Method according to Claim 1, characterized in that, first of all, a number (n) which can be predetermined, of spectral lines in the amplitude spectrum which is present in digital form are in each case combined to form a single spectral line, and in that the single spectral line is allocated the maximum value of the amplitudes of the combined spectral lines as its amplitude value.

3. Method according to Claim 1 or Claim 2, characterized in that the amplitude spectrum which is in digital form has a frequency resolution which is considerably smaller than the period of the modulation frequency to be determined, and in that the amplitude spectrum is specified on a linear scale.

4. Method according to one of the preceding claims, characterized in that the amplitude classes associated with the linear amplitude spectrum, and/or the relevance classes, have an association function which has a linear profile in the transitional region.

5. Method according to one of the preceding claims, characterized in that the two amplitude classes which are associated with one pair of lines are combined using an AND operator, and the result of the combination process is allocated a relevance class which can be predetermined.

6. Method according to one of the preceding claims, characterized in that the cyclic structure is determined using a data processing system which operates using fuzzy-set-theory methods.

7. Method according to one of the preceding claims, characterized in that the amplitude values are weighted in the digitized original spectrum for those spectral lines which are to be formed into a histogram.

8. Method according to one of the preceding claims, characterized in that, for a spectral line which is determined from the residual spectrum in the digitized original spectrum, only those spectral lines having single separations and/or simple fractions of these separations are formed into histograms.

9. Use of the method for determining a cyclic structure as claimed in one of the preceding claims for classification of an aircraft which has components that move cyclically and modulate a radar signal.

10. Use of the method according to Claim 9 for identification and/or classification of a helicopter.

## EP 0 626 583 B1

**Revendications**

1. Procédé de détermination d'une structure périodique dans un spectre de raies dans lequel il existe une ligne de référence spectrale ainsi que plusieurs lignes spectrales contiguës à celle-ci qui sont formées par un processus de modulation périodique,

   - une ligne spectrale étant initialement sélectionnée,
   - les autres lignes spectrales qui font partie de celle-ci et disposées de manière périodique dans le spectre de raies étant déterminées et
   - les paramètres de modulation qui font partie du processus de modulation étant déterminés à partir de la structure périodique du spectre de raies ainsi déterminée, caractérisé en ce
   - qu'un spectre d'amplitude est initialement réalisé sous forme numérique à partir d'un signal d'entrée présent sous forme analogique par un processus d'échantillonnage numérique ainsi qu'une transformation de Fourier,
   - qu'un nombre donné de lignes spectrales contiguës sont à chaque fois regroupées en un intervalle dans le spectre d'amplitude,
   - que la valeur moyenne des amplitudes des lignes spectrales présentes dans chaque intervalle est déterminée dans cet intervalle,
   - que chaque ligne spectrale présente dans chaque intervalle est standardisée par rapport à son amplitude et par rapport à la valeur moyenne des amplitudes correspondant à l'intervalle,
   - que les amplitudes standardisées (An) sont divisées en plusieurs classes d'amplitude (IG, GG, G, SG, UG) qui se chevauchent,
   - qu'un complément périodique est recherché au moins dans l'environnement de la ligne de référence pour chaque ligne spectrale qui s'y trouve de manière à obtenir une paire de lignes composée de la ligne spectrale et d'une ligne de propagation,
   - que chaque paire de lignes est affectée à une classe d'importance en fonction d'une combinaison prédéfinie de ses classes d'amplitude standardisées,
   - qu'une plage de valeurs d'importance prédéfinie est affectée à chaque classe d'importance,
   - qu'une valeur d'importance est déterminée pour chaque paire de lignes,
   - que la valeur d'importance maximale de toutes les paires de lignes qui font partie d'une ligne spectrale est déterminée puis affectée à la ligne spectrale,
   - qu'un spectre résiduel est formé à partir des lignes spectrales dont la valeur d'importance est supérieure à une valeur de seuil prédéfinie,
   - que le nombre de lignes de propagation correspondant à chaque ligne spectrale du spectre résiduel dans le spectre original numérisé est déterminé par une présentation sous forme d'histogramme,
   - que la ligne spectrale qui possède le nombre maximum de lignes de propagation est déterminée à partir de l'histogramme et
   - que la fréquence de modulation est définie à partir de l'écart des fréquences par rapport à la ligne de référence.

2. Procédé selon la revendication 1, caractérisé en ce qu'un nombre donné (n) de lignes spectrales sont initialement regroupées en une ligne spectrale unique dans le spectre d'amplitude présent sous forme numérique et que la valeur maximale des amplitudes des lignes spectrales regroupées est affectée comme valeur d'amplitude à chacune des lignes spectrales.

3. Procédé selon la revendication 1 ou la revendication 2, caractérisé en ce que le spectre d'amplitude présent sous forme numérique possède une résolution de fréquence qui est nettement inférieure à la période de la fréquence de modulation à déterminer et que le spectre d'amplitude est indiqué dans une échelle linéaire.

4. Procédé selon l'une des revendications précédentes, caractérisé en ce que les classes d'amplitude et/ou les classes d'importance qui font partie du spectre d'amplitude linéaire possèdent une fonction d'association qui présente un tracé linéaire dans la zone de transition.

5. Procédé selon l'une des revendications précédentes, caractérisé en ce que les deux classes d'amplitude qui font partie d'une paire de lignes sont combinées à l'aide d'un opérateur UND et qu'une classe d'importance prédéfinie est affectée au résultat de la combinaison.

6. Procédé selon l'une des revendications précédentes, caractérisé en ce que la structure périodique est déterminée à l'aide d'un équipement de traitement de données fonctionnant avec les méthodes dites « Fuzzy-Set-Theory ».

7. Procédé selon l'une des revendications précédentes, caractérisé en ce qu'une pondération des valeurs de l'amplitude est effectuée dans le spectre original numérisé au niveau des lignes spectrales présentées sous forme d'histogramme.

8. Procédé selon l'une des revendications précédentes, caractérisé en ce que seules les lignes spectrales ayant des écarts simples et/ou des fractions simples de ces écarts sont présentées sous forme d'histogramme pour une ligne spectrale déterminée à partir du spectre résiduel dans le spectre original numérisé.

9. Utilisation du procédé de détermination d'une structure périodique selon l'une des revendications précédentes pour classifier un aéronef qui possède des composants qui se déplacent de manière périodique et qui modulent un signal radar.

10. Utilisation du procédé selon la revendication 9 pour détecter et/ou classifier un hélicoptère.

Bezugslinie

Linienspektrum

1      m

---

| Ausdünnung des Linien-spektrums durch Zusammenfassen von Linien | — Schritt 1 |

| Berechnung des lokalen spektralen Pegels | — Schritt 2 |

| Fuzzy-Strukturfilterung und Aufbau eines Spektrums aus periodi-zitätsrelevanten Linien | — Schritt 3 |

| Histogrammbildung von Linienabständen | — Schritt 4 |

Grundperiode im Spektrum

FIG. 1

Fuzzifizierung des
Amplitudenwertes A
jeder Linie

Teilschritt 3.1

Suchen periodischer
Ergänzungen

Teilschritt 3.2

Abarbeiten des
Regelkataloges
(Inferenz)

Teilschritt 3.3

Defuzzifizierung:
Berechnung des
Relevanzwertes

Teilschritt 3.4

Synthese des -
Spektrums aus
relevanten
Linien

Teilschritt 3.5

FIG. 2

Linienverteilung

FIG. 3

S/N (linear)

| Linie | Fortsetzungslinie | | | | |
|---|---|---|---|---|---|
| | IG | GG | G | SG | UG |
| IG | UW | UW | UW | UW | UW |
| GG | UW | WW | WW | WW | WW |
| G | UW | WW | W | W | W |
| SG | UW | WW | W | SW | SW |
| UG | UW | WW | W | SW | HW |

FIG. 4

Ausgangsverteilung

FIG. 5

Relevanzwert